# EUROPEAN PATENT APPLICATION

(11) **EP 4 235 300 A1**
(43) Date of publication of application: **30.08.2023**
(21) Application number: 23156451.9
(22) Date of filing: 14.02.2023
(51) Int. Cl.: G03F 7/00, F16C 29/02, H01L 21/68

(54) **ACTUATOR, STAGE DEVICE, EXPOSURE DEVICE, INSPECTION DEVICE**

(30) Priority: 25.02.2022 JP 2022028320
(71) Applicant: Sumitomo Heavy Industries, Ltd., Tokyo 141-6025 (JP)
(72) Inventor: YOSHIDA, Tatsuya, Yokosuka-shi, Kanagawa, 237-8555, (JP); SUZUKI, Haruka, Yokosuka-shi, Kanagawa, 237-8555, (JP)
(74) Representative: Louis Pöhlau Lohrentz

(57) **Abstract**

To provide an actuator and the like capable of suppressing deformation of a guide. An actuator (10) includes: a slider (20) driven within a movable range along a movement direction (X direction) ; a guide (12) that extends in the X direction to guide the slider (20) and includes a surrounding structure surrounding an outer periphery of the slider (20) and including an opening portion (40) where at least a part thereof is open in a cross section perpendicular to the X direction; an air pad (30) that supplies compressed air between the slider (20) and the guide (12) ; a slider connecting member (44) that penetrates the opening portion (40) to connect the slider (20) inside the surrounding structure and a table (200) outside the surrounding structure; and a guide connecting member (45) that connects edges of the opening portion (40) to each other and is provided at a position where the slider connecting member (44) does not come into contact with the guide connecting member (45) when the slider (20) moves within the movable range.

## Description

### BACKGROUND OF THE INVENTION

### Field of the Invention

The present invention relates to an actuator, a stage device, an exposure device, and an inspection device.

### Description of Related Art

Japanese Patent No. 6893170 discloses that a gas pressure actuator used in a vacuum environment includes a slider driven along a predetermined movement direction by a gas pressure, and a guide extending in the movement direction to guide the slider. An air bearing formed by compressed air supplied between an outer periphery of the slider and an inner periphery of the guide through an air pad allows the slider to float from the guide and move smoothly.

### SUMMARY OF THE INVENTION

In the gas pressure actuator of Japanese Patent No. 6893170, the guide does not surround the entire outer periphery (entire circumference) of the slider and includes an opening portion where a center of a top surface thereof is open. Here, the compressed air supplied between the outer periphery of the slider and the inner periphery of the guide through the air pad applies a pressure to expand the guide from the inside. As a result, the opening portion having relatively low rigidity may be expanded. In particular, since the pressure applied to the outer periphery of the guide is low in a vacuum environment, the guide may be significantly deformed through the opening portion due to a large pressure difference from a high pressure applied to the inner periphery of the guide.

The present invention has been made in view of such a situation, and an object of the present invention is to provide an actuator and the like capable of suppressing deformation of the guide.

In order to solve the above problems, an actuator according to a certain aspect of the present invention includes a slider driven within a movable range along a predetermined movement direction; a guide that extends in the movement direction to guide the slider and includes a surrounding structure surrounding an outer periphery of the slider and including an opening portion where at least a part thereof is open in a cross section perpendicular to the movement direction; a fluid supply portion that supplies a fluid between the slider and the guide; a slider connecting member that penetrates the opening portion to connect the slider inside the surrounding structure and a driven body outside the surrounding structure; and a guide connecting member that connects edges of the opening portion to each other and is provided at a position where the slider connecting member does not come into contact with the guide connecting member when the slider moves within the movable range.

In this aspect, since the rigidity is increased by the guide connecting member that connects the edges of the opening portion of the guide to each other, it is possible to suppress the deformation of the guide due to the pressure of the fluid supplied by the fluid supply portion between the slider and the guide. Since the guide connecting member is provided at a position where the slider connecting member does not come into contact with the guide connecting member when the slider moves within the movable range, the guide connecting member does not interfere with normal driving of the slider.

Another aspect of the present invention is a stage device. This device is a stage device that controls a position of a processing target, and includes a table that holds the processing target and the above-mentioned actuator that displaces the table .

Still another aspect of the present invention is a stage device. This device includes a slider driven within a movable range along a predetermined movement direction; a guide that extends in the movement direction to guide the slider and includes a surrounding structure surrounding an outer periphery of the slider and including an opening portion where at least a part thereof is open in a cross section perpendicular to the movement direction; a gas supply portion that supplies a gas between the slider and the guide; a gas discharge portion that discharges the gas supplied by the gas supply portion from between the outer periphery of the slider and an inner periphery of the surrounding structure; a slider connecting member that penetrates the opening portion to connect the slider inside the surrounding structure and a driven body outside the surrounding structure; a guide connecting member that connects edges of the opening portion to each other and is provided at a position where the slider connecting member does not come into contact with the guide connecting member when the slider moves within the movable range; and a vacuum chamber that accommodates the slider, the guide, the gas supply portion, the gas discharge portion, the slider connecting member, and the guide connecting member in an inside thereof in a vacuum state.

Yet another aspect of the present invention is an exposure device. This device includes the stage device described above that controls a position of an exposure target held by a table.

Still yet another aspect of the present invention is an inspection device. This device includes the stage device described above that controls a position of an inspection target held by a table.

Any combination of the above components and a conversion of the expression of the present invention between methods, devices, systems, recording media, computer programs, and the like are also effective as aspects of the present invention.

According to the present invention, deformation of the guide in the actuator can be suppressed.

### BRIEF DESCRIPTION OF THE DRAWINGS

Fig. 1 is a perspective view schematically showing an actuator.
Fig. 2 is a cross-sectional view of a YZ plane perpendicular to a movement direction (X direction) of a slider.
Fig. 3 is a cross-sectional view of a ZX plane including an opening portion.
Fig. 4 shows a modification example of a guide connecting member.
Fig. 5 shows a configuration example of the guide connecting member.

### DETAILED DESCRIPTION OF THE INVENTION

Hereinafter, embodiments for carrying out the present invention will be described in detail with reference to the drawings. In the description or drawings, the same or equivalent components, members, and processes are designated by the same reference symbols, and duplicate descriptions will be omitted. The scales and shapes of the illustrated parts are set for convenience in order to facilitate the description, and are not to be limitedly interpreted unless otherwise specified. The embodiments are illustrative and do not limit the scope of the present invention in any way. All features and combinations thereof described in the embodiments are not necessarily essential to the invention.

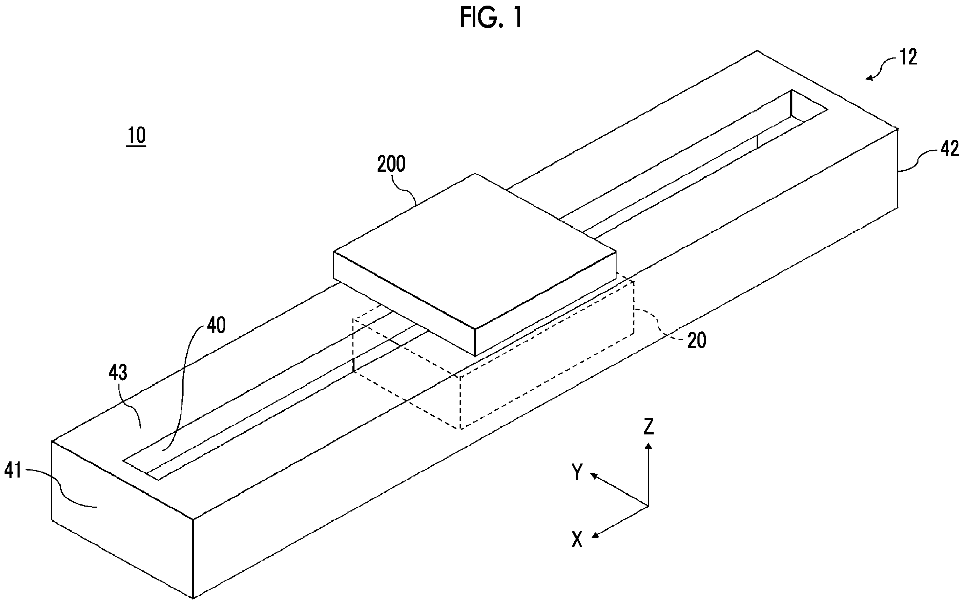

Fig. 1 is a perspective view schematically showing a stage device or an actuator 10 according to an embodiment of the present invention. The actuator 10 is a gas pressure actuator used in a vacuum environment such as in a vacuum chamber and includes a slider 20 that is driven or displaced along a predetermined movement direction by a gas pressure and a guide 12 that extends in the movement direction to guide the slider 20. Hereinafter, the movement direction of the slider 20 and an extension direction of the guide 12 are referred to as an X direction. Further, two directions orthogonal to the X direction and orthogonal to each other are referred to as a Y direction and a Z direction. Typically, the X direction and the Y direction are directions orthogonal to each other in a horizontal plane, and the Z direction is a vertical direction.

The slider 20 has a substantially rectangular parallelepiped shape that is long in the movement direction, and the guide 12 includes a substantially rectangular parallelepiped internal space that accommodates the slider 20 so as to be movable. A length of the internal space in the X direction is larger than a length of the slider 20 in the X direction such that the slider 20 can move in the internal space of the guide 12 along the movement direction. Here, a difference between the length of the internal space of the guide 12 in the X direction and the length of the slider 20 in the X direction is a maximum value of a width of a movable range of the slider 20. Both end portions of the guide 12 in the X direction are blocked by a first end plate 41 and a second end plate 42, and a distance between inner peripheral surfaces of the first end plate 41 and the second end plate 42 is the length of the internal space of the guide 12 in the X direction.

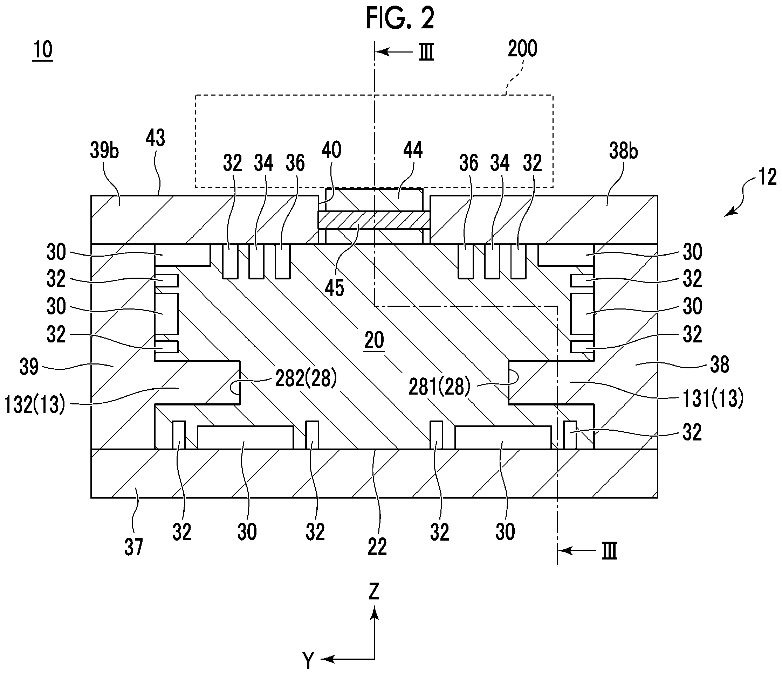

As shown in Fig. 2 to be described later, the guide 12 includes a surrounding structure surrounding a rectangular outer periphery of the slider 20 and including an opening portion 40 where at least a part thereof is open in a cross section (YZ plane) perpendicular to the movement direction (X direction). In the example of Fig. 1, the opening portion 40 is provided on a top surface 43 or an upper surface of the guide 12. The opening portion 40 is a rectangular hole that is long in the movement direction of the slider 20, and is terminated by the first end plate 41 and the second end plate 42. Therefore, the opening portion 40 has a length in the X direction equal to that of the internal space of the guide 12 and a width in the Y direction large enough to allow the slider connecting member 44 to pass therethrough as shown in Fig. 2. The slider connecting member 44 penetrates the opening portion 40 in the Z direction to connect a top portion of the slider 20 inside the surrounding structure of the guide 12 and a bottom portion of a stage or table 200 serving as a driven body outside the surrounding structure of the guide 12. A cross-sectional shape of the slider 20 is not limited to a rectangular shape, and may be any shape such as a trapezoidal shape disclosed in Japanese Patent No. 6893170 or other polygonal shapes, a circular shape, or an elliptical shape.

The actuator 10 of the present embodiment is applied to, for example, a semiconductor manufacturing device or flat panel display manufacturing device (FPD) such as an exposure device, an ion implanter, a heat treatment device, an ashing device, a sputtering device, a dicing device, an inspection device, and a cleaning device. However, in this case, the table 200 holds a semiconductor wafer or the like as a processing target (also referred to as an exposure target in a case of the exposure device and an inspection target in a case of the inspection device), or the semiconductor wafer or the like as a processing target is placed on the table 200. When the slider 20 is driven in the X direction by a gas pressure as described later, the table 200 connected to the slider 20 by the slider connecting member moves in the X direction. For this reason, while precisely controlling a position of the semiconductor wafer or the like as a processing target which is placed on the table 200, it is possible to accurately perform desired processing on each part thereof. In Fig. 1, only the actuator 10 that is driven or displaced in the X direction is illustrated for the sake of simplification of description, but in addition to this, an actuator that is driven or displaced in other translational directions such as the Y direction and the Z direction may be similarly configured and juxtaposed.

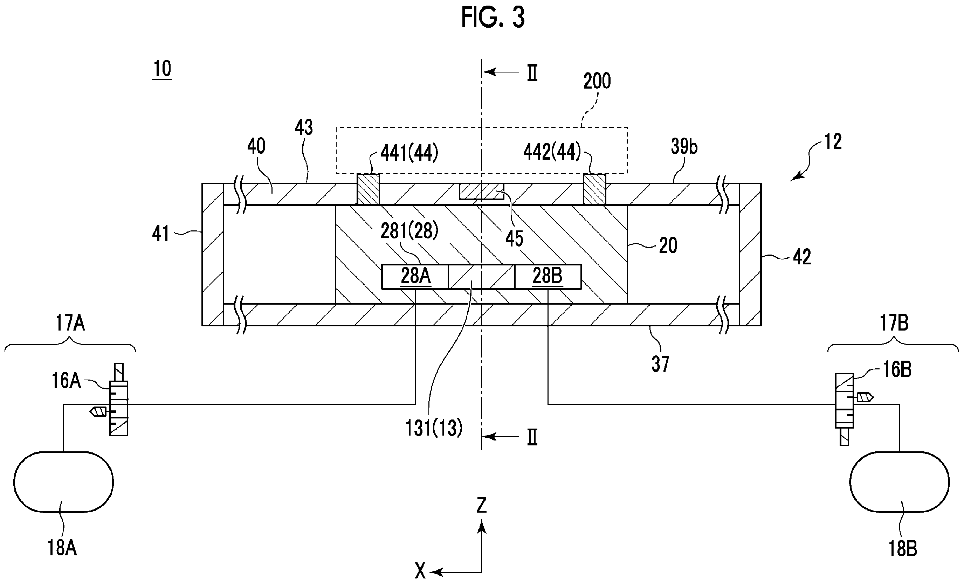

Fig. 2 is a cross-sectional view of the YZ plane perpendicular to the movement direction (X direction) of the slider 20, and Fig. 3 is a cross-sectional view of a ZX plane including the opening portion 40. The cross sections of Figs. 2 and 3 are selected such that the guide connecting member 45, which will be described later, is shown. Fig. 2 is a cross-sectional view taken along line II-II of Fig. 3, and Fig. 3 is a cross-sectional view taken along line III-III of Fig. 2.

As shown in Fig. 2, the guide 12 includes the surrounding structure that surrounds the rectangular outer periphery of the slider 20. The surrounding structure is constituted by a bottom plate 37 facing a bottom portion 22 of the slider 20, a first side plate 38 facing a first side portion 24 of the slider 20, a second side plate 39 facing a second side portion 26 of the slider 20, and top plates 38b and 39b facing a top portion of the slider 20. It can be said that the top plates of the guide 12 are divided into two substantially equal portions 38b and 39b by the opening portion 40 extending or crossing a center of the Y direction in the X direction. In this way, the guide 12 totally constrains the bottom portion 22, the first side portion 24, and the second side portion 26 of the slider 20 by three surfaces of the bottom plate 37, the first side plate 38, and the second side plate 39 (three-side constraint), and partially constrains the top portion of the slider 20 by the top plates 38b and 39b divided into two by the opening portion 40.

The slider 20 constrained from all sides by the surrounding structure of the guide 12 can be guided by the guide 12 and move in the X direction. A plurality of air pads 30 as a fluid supply portion or a gas supply portion that supplies a fluid or a gas between the outer periphery of the slider 20 and the inner periphery of the surrounding structure of the guide 12 are provided at the bottom portion 22, the first side portion 24, the second side portion 26, the top portion of the slider 20. Specifically, each air pad 30 ejects a high-pressure gas such as compressed air supplied from a supply/exhaust system (not illustrated) to form an air bearing, and causes the slider 20 to float from the guide 12. The slider 20 can smoothly move in the X direction without substantially contacting the guide 12 via minute gaps or layers such as compressed air formed between the outer periphery of the slider 20 and the inner periphery of the surrounding structure of the guide 12.

Since the actuator 10 of the present embodiment is used in a vacuum environment such as in a vacuum chamber, the compressed air ejected from the air pad 30 must not leak to the vacuum environment through the opening portion 40 or the like. For this reason, the slider 20 is provided with exhaust grooves 32, 34, and 36 for differential exhaust so as to surround each of the air pads 30. Each of the exhaust grooves 32, 34, and 36 constitutes a fluid discharge portion or a gas discharge portion that discharges a fluid or gas supplied by each air pad 30 serving as the fluid supply portion or the gas supply portion to the outside of the actuator 10 from between the outer periphery of the slider 20 and the inner periphery of the surrounding structure of the guide 12. Each of the exhaust grooves 32, 34, and 36 is a long groove formed over substantially the entire length of the slider 20 in the X direction.

Each exhaust groove 32 provided on both sides of all the air pads 30 is open to the atmosphere. An exhaust pump may be provided between each exhaust groove 32 and the atmosphere. The exhaust grooves 34 and 36 are provided at positions adjacent to or close to the opening portion 40, and reliably prevent the compressed air from leaking into the vacuum environment through the opening portion 40. The exhaust groove 34 is connected to a low vacuum exhaust pump that generates a low vacuum pressure (100 kPa to 100 Pa), and the exhaust groove 36 closer to the opening portion 40 is connected to a medium vacuum exhaust pump that generates a pressure of a higher vacuum level (lower pressure level) than that of the exhaust groove 34, for example, a medium vacuum pressure (100 Pa to 0.1 Pa).

As shown in Fig. 2, a side surface (first side portion 24 and/or second side portion 26) of the slider 20 is provided with an air servo chamber 28 as a differential pressure drive space at a position facing an inner periphery of the first side plate 38 and/or the second side plate 39 of the guide 12. Hereinafter, the air servo chamber 28 provided on the first side portion 24 of the slider 20 is also referred to as an air servo chamber 281, the air servo chamber 28 provided on the second side portion 26 of the slider 20 is also referred to as an air servo chamber 282, and when there is no need to distinguish between the two, they are collectively referred to as the air servo chamber 28. The first side plate 38 of the guide 12 includes a piston block 131 as a partitioning portion extending into the air servo chamber 281, and the second side plate 39 of the guide 12 includes a piston block 132 as a partitioning portion extending into the air servo chamber 282. Hereinafter, the piston blocks 131 and 132 will be collectively referred to as a piston block 13.

As shown in Fig. 3, each piston block 13 inserted into each air servo chamber 28 in the Y direction partitions each air servo chamber 28 into a first servo chamber 28A serving as a first pressure chamber and a second servo chamber 28B serving as a second pressure chamber along the X direction. As schematically shown in Fig. 3, supply/exhaust systems 17A and 17B as differential pressure drive units that supply and/or discharge a pressure control fluid or a pressure control gas such as compressed air between the servo chambers 28A and 28B are provided. The supply/exhaust systems 17A and 17B include compressed gas supply sources 18A and 18B that supply the compressed gas and servo valves 16A and 16B that control a pressure of the compressed gas to perform supply and discharge of the compressed gas between the servo chambers 28A and 28B, respectively. The slider 20 is driven along the movement direction according to a differential pressure between a pressure of the first servo chamber 28A controlled by the supply/exhaust system 17A and a pressure of the second servo chamber 28B controlled by the supply/exhaust system 17B.

Here, a range of the air servo chamber 28 in the X direction defines the movable range of the slider 20 along the movement direction (X direction). Since the piston block 13 (guide 12) itself that relatively moves inside the air servo chamber 28 (slider 20) in the X direction has a significant length in the X direction, (a maximum value of) a width of the movable range, which is a distance in the X direction that the slider 20 can actually move, is a difference between a length of the air servo chamber 28 in the X direction and a length of the piston block 13 in the X direction. In other words, the length of the air servo chamber 28 as the differential pressure drive space in the X direction is larger than the width of the movable range of the slider 20 by the length of the piston block 13 in the X direction.

As shown in Fig. 3, the slider connecting member 44 that penetrates the opening portion 40 of the top surface 43 of the guide 12 in the Z direction to connect the top portion of the slider 20 and the bottom portion of the table 200 includes a first slider connecting member 441 and a second slider connecting member 442 provided along the X direction at a distance equal to or greater than the width of the movable range of the slider 20 and/or the length of the air servo chamber 28 in the X direction. Hereinafter, the first slider connecting member 441 and the second slider connecting member 442 are collectively referred to as the slider connecting member 44. As shown in Fig. 2, a width of each slider connecting member 44 in the Y direction is smaller than a width of the opening portion 40 of the guide 12 in the Y direction. Each slider connecting member 44 is movable in the X direction (left-right direction in Fig. 3) integrally with the slider 20 and the table 200 in the opening portion 40 extending in the X direction.

As shown in Fig. 2, the guide connecting member 45 is a columnar or rod-shaped member that connects edges of the opening portion 40 of the guide 12 to each other in the Y direction. Here, the Y direction in which the guide connecting member 45 connects the edges of the opening portion 40 to each other is orthogonal to the Z direction in which the slider connecting member 44 connects the slider 20 and the table 200. In addition, the Y direction in which the guide connecting member 45 connects the edges of the opening portion 40 to each other and the Z direction in which the slider connecting member 44 connects the slider 20 and the table 200 are orthogonal to the X direction which is the movement direction of the slider 20.

As shown in Fig. 3, the guide connecting member 45 is provided at a position where the first slider connecting member 441 and the second slider connecting member 442 do not come into contact with the guide connecting member 45 when the slider 20 moves within the movable range. Specifically, the guide connecting member 45 is provided at a position overlapping the piston block 13 along the X direction within the movable range of the slider 20 and/or within the range of the air servo chamber 28 in the X direction. In addition, the guide connecting member 45 is provided between the first slider connecting member 441 and the second slider connecting member 442 along the X direction.

When the slider 20 moves within the movable range, the guide connecting member 45moves relative to the first slider connecting member 441 and the second slider connecting member 442 in the X direction. However, since the first slider connecting member 441 and the second slider connecting member 442 are provided outside the movable range of the slider 20 and/or outside the range of the air servo chamber 28 in the X direction, the guide connecting member 45 does not come into contact with either the first slider connecting member 441 or the second slider connecting member 442. That is, the guide connecting member 45 does not interfere with normal driving of the slider 20.

According to the present embodiment, as shown in Fig. 2, since rigidity is increased by the guide connecting member 45 that connects the edges of the opening portion 40 of the guide 12 to each other, deformation of the guide 12 due to the pressure of the compressed air supplied between the outer periphery of the slider 20 and the inner periphery of the guide 12 by the plurality of the air pads 30 can be suppressed. As shown in Fig. 1, the opening portion 40 is hard to be deformed at both end portions in the X direction fixed to the first end plate 41 and the second end plate 42 and is easily expanded is at a center portion by the pressure of the compressed air of the air pad 30. In the present embodiment, as shown in Fig. 3, by particularly providing the guide connecting member 45 at the center portion of the opening portion 40 along the X direction, which is easily deformable, the deformation of the guide 12 can be effectively suppressed.

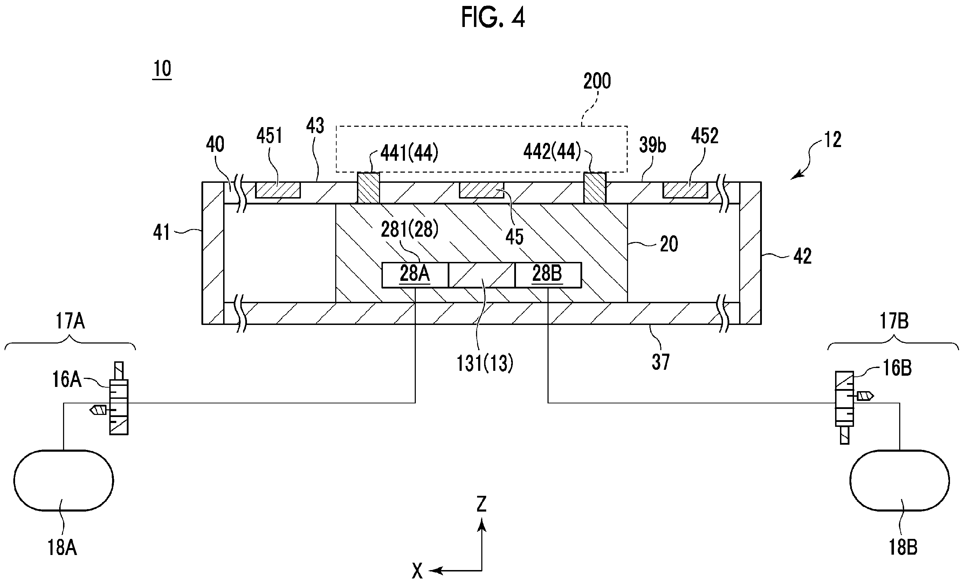

In addition, in order to suppress deformation of the opening portion 40 in the vicinity of both end portions in the X direction, a first end guide connecting member 451 and a second end guide connecting member 452 shown in Fig. 4 may be provided in addition to or in place of the guide connecting member 45 provided at the center portion of the opening portion 40. In a case where the guide connecting member 45 at the center portion of the opening portion 40 is not provided, the slider 20 and the table 200 may be connected by one slider connecting member 44 instead of the first slider connecting member 441 and the second slider connecting member 442. Since the first end guide connecting member 451 and the second end guide connecting member 452 are provided outside along the X direction from both ends of the movable range of the slider 20, the first end guide connecting member 451 and the second end guide connecting member 452 do not come into contact with the slider connecting member 44 even though the slider 20 moves within the movable range.

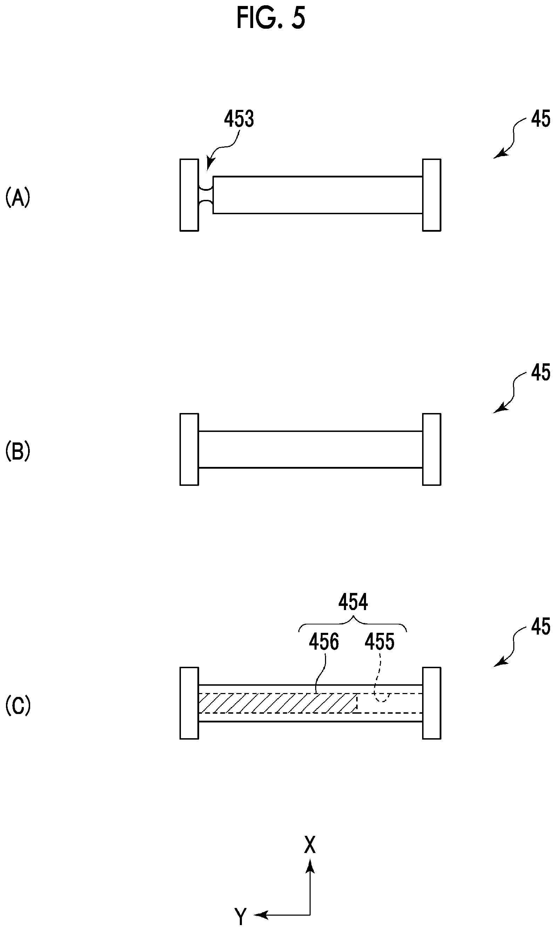

Fig. 5 shows a configuration example of the guide connecting member 45. The guide connecting member 45 in the example of (A) of Fig. 5 includes a stress relaxation portion 453 that relaxes stress by being deformed. The stress relaxation portion 453 is deformed to release the stress such that the opening portion 40 is not expanded by the stress when the guide connecting member 45 is attached to the opening portion 40 of the guide 12. As shown in (A) of Fig. 5, the stress relaxation portion 453 may be configured by a flexible portion or an elastically deformable portion that is narrower in width or the like than other portions and can bend or may be configured by a mechanical component such as a hinge that allows an opening/closing operation or a bending operation.

The guide connecting member 45 may be a simple columnar or rod-shaped member as shown in (B) of Fig. 5. In this case, it is preferable to use the guide connecting member 45 that is precision-machined such that an excessive load is not applied to the opening portion 40 of the guide 12 when the guide connecting member 45 is attached. As shown in (C) of Fig. 5, the guide connecting member 45 may include a resistance applying portion 454 that applies resistance to deformation that expands the opening portion 40. In the example of (C) of Fig. 5, the resistance applying portion 454 is configured by a tubular cylinder 455 and a columnar piston 456 inserted into the cylinder 455. A length of an internal space of the cylinder 455 in the Y direction is larger than a length of the piston 456 in the Y direction, and a space between a tip end (right end) of the piston 456 and a base end (right end) of the cylinder 455 is in a low pressure state such as a vacuum state. When the compressed air of the air pad 30 applies a pressure to expand the opening portion 40, that is, when a pressure is applied to separate the cylinder 455 and the piston 456 along the Y direction, the internal space of the cylinder 455 in a low pressure state generates a drag force. Therefore, it is possible to effectively prevent the opening portion 40 from being expanded. The resistance applying portion 454 is not limited to one that passively generates a drag force in response to a pressure that expands the opening portion 40 of the guide 12 in the Y direction, such as the cylinder 455 and the piston 456, and may be configured by an actuator such as a piezoelectric element that actively or adaptively applies resistance or force to prevent expansion or deformation of the opening portion 40.

Hereinabove, the present invention has been describedbased on the embodiments. The embodiments are examples, and it is understood by those skilled in the art that various modification examples are possible for each of combinations of the respective components and the respective processing processes, and that such modification examples are also within the scope of the present invention.

The functional configuration of each device described in the embodiments can be realized by hardware resources or software resources, or by cooperation of the hardware resources and the software resources. Processors, ROMs, RAMs, or other LSIs can be used as the hardware resources. Programs such as operating systems and applications can be used as the software resources.

### Brief Description of the Reference Symbols

- 10: Actuator
- 12: Guide
- 13: Piston block
- 17A: Supply/exhaust system
- 17B: Supply/exhaust system
- 20: Slider
- 28: Air servo chamber
- 30: Air pad
- 32: Exhaust groove
- 34: Exhaust groove
- 36: Exhaust groove
- 40: Opening portion
- 41: First end plate
- 42: Second end plate
- 43: Top surface
- 44: Slider connecting member
- 45: Guide connecting member
- 200: Table
- 441: First slider connecting member
- 442: Second slider connecting member
- 451: First end guide connecting member
- 452: Second end guide connecting member
- 453: Stress relaxation portion
- 454: Resistance applying portion

## Claims

1. An actuator (10) comprising:
a slider (20) driven within a movable range along a predetermined movement direction;
a guide (12) that extends in the movement direction to guide the slider (20) and includes a surrounding structure surrounding an outer periphery of the slider (20) and including an opening portion (40) where at least a part thereof is open in a cross section perpendicular to the movement direction;
a fluid supply portion (30) that supplies a fluid between the slider (20) and the guide (12);
a slider connecting member (44) that penetrates the opening portion (40) to connect the slider (20) inside the surrounding structure and a driven body (200) outside the surrounding structure; and
a guide connecting member (45) that connects edges of the opening portion (40) to each other and is provided at a position where the slider connecting member (44) does not come into contact with the guide connecting member (45) when the slider (20) moves within the movable range.

2. The actuator (10) according to claim 1, wherein the slider connecting member (44) includes a first slider connecting member (441) and a second slider connecting member (442) provided at a distance equal to or greater than a width of the movable range along the movement direction, and
the guide connecting member (45) is provided between the first slider connecting member (441) and the second slider connecting member (442).

3. The actuator (10) according to claim 2, wherein the guide connecting member (45) is provided in the movable range.

4. The actuator (10) according to any one of claims 1 to 3, wherein the guide connecting member (45) includes a first end guide connecting member (451) and a second end guide connecting member (452) that are provided outside along the movement direction from both ends of the movable range.

5. The actuator (10) according to any one of claims 1 to 4, wherein the guide connecting member (45) includes a stress relaxation portion (453) that relaxes stress by being deformed.

6. The actuator (10) according to any one of claims 1 to 5, wherein the guide connecting member (45) includes a resistance applying portion (454) that applies resistance to deformation that expands the opening portion (40).

7. The actuator (10) according to any one of claims 1 to 6, wherein a direction in which the slider connecting member (44) connects the slider (20) and the driven body (200) and a direction in which the guide connecting member (45) connects the edges of the opening portion (40) to each other are substantially orthogonal to each other.

8. The actuator (10) according to any one of claims 1 to 7, wherein both end portions of the guide (12) are blocked.

9. A stage device that controls a position of a processing target, comprising:
a table (200) that holds the processing target; and
the actuator (10) according to any one of claims 1 to 8 that displaces the table (200).

10. An exposure device comprising:
the stage device according to claim 9 that controls a position of an exposure target held by the table (200).

11. An inspection device comprising:
the stage device according to claim 9 that controls a position of an inspection target held by the table (200).

12. A stage device comprising:
a slider (20) driven within a movable range along a predetermined movement direction;
a guide (12) that extends in the movement direction to guide the slider (20) and includes a surrounding structure surrounding an outer periphery of the slider (20) and including an opening portion (40) where at least a part thereof is open in a cross section perpendicular to the movement direction;
a gas supply portion (30) that supplies a gas between the slider (20) and the guide (12);
a gas discharge portion (32, 34, 36) that discharges the gas supplied by the gas supply portion from between the outer periphery of the slider and an inner periphery of the surrounding structure;
a slider connecting member (44) that penetrates the opening portion (40) to connect the slider (20) inside the surrounding structure and a driven body (200) outside the surrounding structure;
a guide connecting member (45) that connects edges of the opening portion (40) to each other and is provided at a position where the slider connecting member (44) does not come into contact with the guide connecting member (45) when the slider (20) moves within the movable range; and
a vacuum chamber that accommodates the slider (20), the guide (12), the gas supply portion (30), the gas discharge portion (32, 34, 36), the slider connecting member (44), and the guide connecting member (45) in an inside thereof in a vacuum state.
